# EUROPEAN PATENT SPECIFICATION

(11) **EP 3 614 443 B1**
(45) Date of publication and mention of the grant of the patent: **05.03.2025**
(21) Application number: 17906291.4
(22) Date of filing: 10.08.2017
(51) Int. Cl.: H01L 31/0224, H01L 31/05

(54) **DENSELY-ARRANGED SOLAR CELL STRING AND PREPARATION METHOD, AND ASSEMBLY AND SYSTEM THEREOF**
DICHT ANGEORDNETER SOLARZELLENSTRANG UND HERSTELLUNGSVERFAHREN UND MONTAGE UND SYSTEM DAVON
CHAÎNE DE CELLULES SOLAIRES AGENCÉES DE MANIÈRE DENSE ET PROCÉDÉ DE PRÉPARATION, ENSEMBLE ET SYSTÈME ASSOCIÉS

(30) Priority: 20.04.2017 CN 201710260382
(43) Date of publication of application: 26.02.2020
(73) Proprietor: Jolywood (Taizhou) Solar Technology Co., Ltd., Taizhou, Jiangsu 225500 (CN)
(72) Inventor: LIN, Jianwei, Taizhou, Jiangsu 225500 (CN); LIU, Zhifeng, Taizhou, Jiangsu 225500 (CN); JI, Genhua, Taizhou, Jiangsu 225500 (CN); LIU, Yong, Taizhou, Jiangsu 225500 (CN)
(74) Representative: Plasseraud IP
(86) International application number: PCT/CN2017/000517
(87) International publication number: WO 2018/191831

(56) References cited:
- CN-A- 106 252 446
- CN-A- 106 920 854
- CN-U- 202 888 193
- US-A1- 2012 325 282
- US-A1- 2014 124 014
- US-A1- 2017 077 343

## Description

### TECHNICAL FIELD

The present application relates to the technical field of solar cells and in particular to a densely-arranged solar cell string and a preparation method thereof, a solar cell module and a solar cell system.

### BACKGROUND

Solar cell modules are photovoltaic power generation units that convert light energy into electrical energy. Low production cost and high energy conversion efficiency have always been the goal pursued by the solar cell modules. For a conventional solar cell module, among the cells in the module, a cathode of a cell and an anode of another cell are connected to form a solar cell string. Then, a front layer material, a packaging material, the solar cell string, the packing material and a back layer material are laminated to form the solar cell module. In the process of connecting the cells in series, since the cathode and anode of the cell are located on two sides of the cell, respectively, the electrode on a front surface of a cell needs to be connected to the electrode on a back surface of an adjacent cell by welding. Since the welding strip has a certain thickness, a certain gap used for releasing for the shearing force needs to be reserved between the cells connected in series, in order to avoid the breakage of the cells. Generally, the gap between the cells is 1 to 3 mm. Since there are no cells in the gap region, the power of the module will certainly be lost.

CN104919597A has disclosed a method for configuring a cell string, wherein "the cell string body includes at least one cell string; the cell string includes a plurality of arranged crystalline silicon cells; and, a front surface of a next crystalline silicon cell and a back surface of a previous crystalline silicon cell are stacked to form an electrical connection". This solution can increase the utilization area of cells in an effective region of the module and improve the power of the module. However, the solution has the following disadvantages: 1) in the solution disclosed therein, main grid lines are perpendicular to the series-connection of the cells, and the current can be collected only after passing through fine grid lines and then flowing into welding points; and, 2) adjacent cells are connected by a conductive adhesive, so some problems may occur in the mechanical strength and the connection firmness during the actual production process.

In addition, US 2017/0077343 A1 has disclosed a shingled solar module with the conductive adhesive or solder paste being disposed on the discrete contact pads.

### SUMMARY

An objective of the present application is to provide a densely-arranged solar cell string and a preparation method thereof, a solar cell module and a solar cell system. According to the method for preparing a densely-arranged solar cell string provided by the present application, no gap is generated between cells during the series-connection process, so that the utilization area of cells in an effective region of a module is increased and the power of the module is improved.

The present application provides a method for preparing a densely-arranged solar cell string. The technical solution is recited in claim 1. The method includes the following steps:
(1) preparing a solar cell, wherein main grids and fine grids of the solar cell are perpendicular to each other; the main grids are segmented electrodes, and welding points for electrical connection between cells are arranged at ends of the segmented main grids; the positions of the main grid welding points on the back surface and the positions of the main grid welding points on the front surface are symmetrical about a center; and, a cell cutting region is further provided on the solar cell, and the cell cutting region is perpendicular to the main grids;
(2) printing a strip-shaped hot melt adhesive: printing the strip-shaped hot melt adhesive at the region corresponding to the welding points of the segmented main grids in a direction perpendicular to the main grids, wherein the welding points are exposed from the hot melt adhesive;
(3) cutting the cell: cutting, along the cell cutting region, the solar cell into a plurality of small cells;
(4) coating a conductive adhesive or solder paste: coating the conductive adhesive or solder paste at the main grid welding points on the front surfaces of the small cells;
(5) adhering the small cells: superposing main grid welding points on a back surface of one small cell onto main grid welding points on a front surface another small cell, and heating so that the two small cells are electrically connected through the conductive adhesive or solder paste; and, melting the hot melt adhesive while heating, and solidifying the hot melt adhesive after cooling, so that the two small cells are closely adhered together and the welding points on the two small cells form firm ohmic contact; and
(6) repeating the step (5) for the plurality of small cells so that the plurality of small cells are successively connected to form a solar cell string.

Wherein, there are 3 to 15 main grids each having a width of 100 to 1200 µm.

Wherein, the cell cutting region has a width of 1 to 2 mm; the hot melt adhesive has a width of 1 to 3 mm, and the welding points are exposed from the hot melt adhesive; and, the hot melt adhesive needs to be dried at a temperature of below 150°C after printed.

Wherein, in the step (3), the cutting is laser cutting.

Wherein, in the step (5), the heating is resistance wire heating or infrared heating.

Another aspect of the present application provides a densely-arranged solar cell string recited in claim 6, including solar cell units, wherein fine grids, main grids and main grid welding points are provided on front and back surfaces of the solar cell units, and the main grid welding points are arranged at ends of the main grids; a hot melt adhesive is coated on the front surfaces of the solar cell units along a direction of the fine grids, the hot melt adhesive is disconnected in a region of the main grid welding points, and a conductive adhesive or solder paste is coated at the main grid welding points; the back surface of one solar cell unit is superposed onto the front surface of another solar cell unit along a long-side direction, and the width of an superposed region of the two solar cell units is the width of the main grid wielding points; and, the main welding points on the back surface of one solar cell unit come into ohmic contact with the main grid welding points on the front surface on another solar cell unit through the conductive adhesive or solder paste, so that the two solar cell units are adhered together through the hot melt adhesive.

Wherein, electrodes on the back and front surfaces of the solar cell units are H-type electrodes, and the main grids and the fine grids are perpendicular to each other.

Wherein, the hot melt adhesive has a width of 1 to 3 mm.

Still another aspect of the present application provides a densely-arranged solar cell module, including a front layer material, a packaging material, a solar cell string, the packaging material and a back layer material which are successively arranged from the top down, the solar cell string being the solar cell string described above.

Yet another aspect of the present application provides a solar cell system, including at least one solar cell module connected in series, wherein the solar cell module is the solar cell module described above.

The present application have the following beneficial effects.

The technical advantages of the present application are mainly embodied as follows:
1) two adjacent cells are closely adhered by a hot melt adhesive, so the mechanical strength and firm ohmic contact of the welding points are ensured, and the hot melt adhesive can also prevent the flow of the conductive adhesive;
2) the cell is in an H-type grid line design, and the main grids are parallel to the series-connection direction of the cell, so this configuration can significantly improve the current collection efficiency; 3) since the conductive adhesive is only coated at the main grid welding points, the amount of the conductive adhesive is saved; and, 4) since no gap is generated between cells during the series-connection process, the utilization area of cells in an effective region of a module is increased and the power of the module is improved.

### BRIEF DESCRIPTION OF THE DRAWINGS

Fig. 1 is a diagram of a cell structure after step 1 in a method for preparing a densely-arranged solar cell string according to an embodiment of the present application;
Fig. 2 is a diagram of a cell structure after step 2 in the method for preparing a densely-arranged solar cell string according to an embodiment of the present application;
Fig. 3 is a diagram of a cell structure after step 3 in the method for preparing a densely-arranged solar cell string according to an embodiment of the present application;
Fig. 4 is a diagram of a cell structure after step 4 in the method for preparing a densely-arranged solar cell string according to an embodiment of the present application;
Fig. 5 is a diagram of a cell structure after step 5 in the method for preparing a densely-arranged solar cell string according to an embodiment of the present application; and
Fig. 6 is a diagram of a cell structure after step 6 in the method for preparing a densely-arranged solar cell string according to an embodiment of the present application.

### DETAILED DESCRIPTION

The present application will be described below in detail with reference to the accompanying drawings by embodiments. It is to be noted that the embodiments to be described are merely provided for understanding of the present application and not intended to limit the present application.

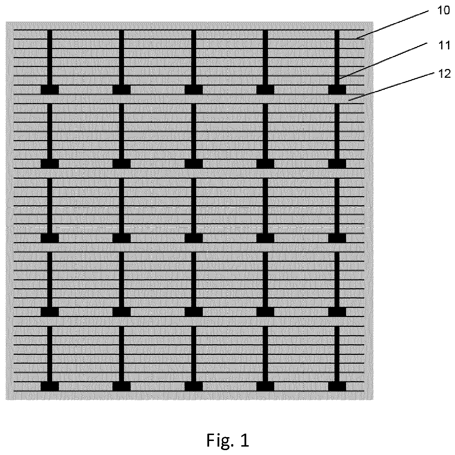

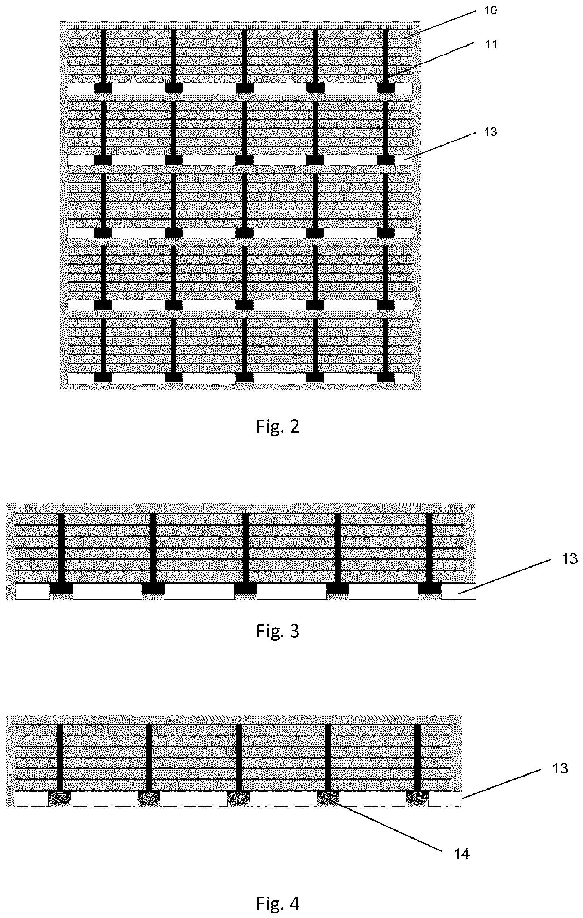

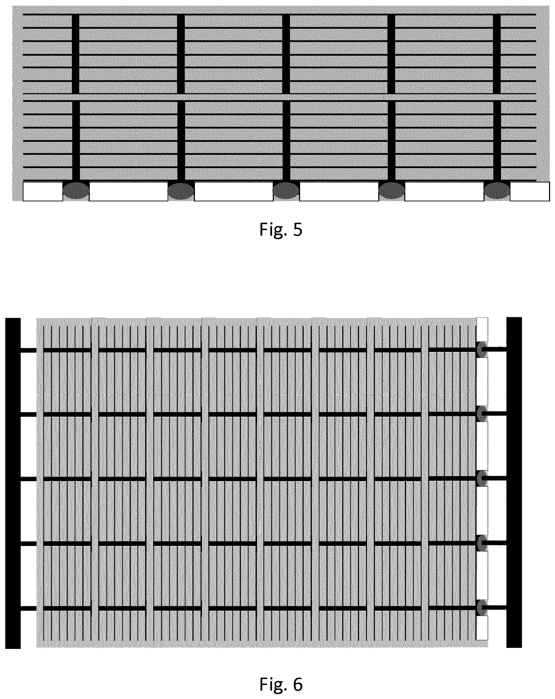

Referring to Figs. 1-6, a method for preparing a densely-arranged solar cell string in this embodiment includes the following steps.
(1) Preparing a solar cell: as shown in Fig. 1, electrodes on the front surface are H-type electrodes. Main grids 11 and fine grid lines 10 are perpendicular to each other, wherein the main grids 11 are segmented, and welding points used for electrical connection between cells are arranged at ends of the segmented main grids. There are 3 to 15 main grids 11 each having a width of 100 to 1200 µm. Meanwhile, a cell cutting region 12 is provided. The cutting region 12 is perpendicular to the main grids 11, and has a width of 1 to 2 mm. The electrode structure on the back surface of the cell is also H-type electrodes, main grids are segmented, and welding points are arranged at ends of the segmented main grids. The positions of the welding points on the back surface and the positions of the welding points on the front surface are symmetrical about a center.
(2) Printing a strip-shaped hot melt adhesive 13: the strip-shaped hot melt adhesive 13 is printed at the region corresponding to the welding points of the segmented main grids in a direction perpendicular to the main grids, but the welding points need to be exposed. The hot melt adhesive has a width of 1 to 3 mm. The hot melt adhesive needs to be dried at a temperature of below 150°C after printed.
(3) Cutting the cell: along the cell cutting region 12, the cell is cutting into a plurality of small cells, as shown in Fig. 2. As shown Fig. 3, the cutting is preferably laser cutting.
(4) A conductive adhesive or solder paste 14 is located at the main grid lines 11 on the front surface of the cell. As shown in Fig. 14, the conductive adhesive or solder paste is not coated at the welding points on the back surface of the cell.
(5) As shown in Fig. 5, two small cells are adhered, wherein main grid welding points on a back surface of one small cell are superposed onto main grid welding points on a front surface of another small cell, and the two small cells are heated by in a resistance wire heating manner or an infrared heating manner, so that the two small cells are electrically connected through the conductive adhesive or solder paste 14. The hot melt adhesive is molten while heating, and then solidified after cooling, so that the two small cells are closely adhered together to ensure firm ohmic contact of the welding points of the two cells.
(6) As shown in Fig. 6, the step (5) is repetitively executed for the plurality of small cells, so that the plurality of small cells are successively connected to form a solar cell string.

In the present application, two adjacent cells are closely adhered by a hot melt adhesive, so the mechanical strength and firm ohmic contact of the welding points are ensured, and the hot melt adhesive can also prevent the flow of the conductive adhesive; 2) the cell is in an H-type grid line design, and the main grids are parallel to the series-connection direction of the cell, so this configuration can significantly improve the current collection efficiency; 3) since the conductive adhesive is only coated at the main grid welding points, the amount of the conductive adhesive is saved; and, 4) since no gap is generated between cells during the series-connection process, the utilization area of cells in an effective region of a module is increased and the power of the module is improved.

This embodiment further provides a densely-arranged solar cell string, including solar cell units. Fine grids 10, main grids 11 and main grid welding points are provided on front and back surfaces of the solar cell units, and the main grid welding points are arranged at ends of the main grids 11. A hot melt adhesive 13 is coated on the front surfaces of the solar cell units along a direction of the fine grids 10, the hot melt adhesive 13 is disconnected in a region of the main grid welding points, and a conductive adhesive or solder paste 14 is coated at the main grid welding points. The back surface of one solar cell unit is superposed onto the front surface of another solar cell unit along a long-side direction. The width of an superposed region of the two solar cell units is the width of the main grid wielding points. The main welding points on the back surface of one solar cell unit come into ohmic contact with the main grid welding points on the front surface on another solar cell unit through the conductive adhesive or solder paste 14, so that the two solar cell units are adhered together through the hot melt adhesive 13.

Preferably, electrodes on the front and back surfaces of the solar cell are H-type electrodes, and the main grids and the fine grids are perpendicular to each other.

Preferably, the hot melt adhesive has a width of 1 to 3 mm.

This embodiment further provides a densely-arranged solar cell module, including a front layer material, a packaging material, a solar cell string, the packaging material and a back layer material which are successively arranged from the top down, the solar cell string being the solar cell string described above.

This embodiment further provides a solar cell system, including at least one solar cell module connected in series, wherein the solar cell module is the solar cell module described above.

## Claims

1. A method for preparing a densely-arranged solar cell string, comprising the following steps:
(1) preparing a solar cell, wherein main grids (11) and fine grids (10) of the solar cell are perpendicular to each other; the main grids (11) are segmented electrodes, and welding points for electrical connection between cells are arranged at ends of the segmented main grids (11); wherein the fine grids (10), the main grids (11) and the main grid welding points are provided on front and back surfaces of the solar cell; the positions of the main grid welding points on the back surface and the positions of the main grid welding points on the front surface are symmetrical about a center; and, a cell cutting region (12) is further provided on the solar cell, and the cell cutting region (12) is perpendicular to the main grids (11);
(2) printing a strip-shaped hot melt adhesive (13): printing the strip-shaped hot melt adhesive (13) at the region corresponding to the welding points of the segmented main grids (11) in a direction perpendicular to the main grids (11), and exposing the welding points;
(3) cutting the cell: cutting, along the cell cutting region (12), the solar cell into a plurality of small cells;
(4) coating a conductive adhesive or solder paste (14): coating the conductive adhesive or solder paste (14) at the main grid welding points on the front surfaces of the small cells;
(5) adhering the small cells: superposing main grid welding points on a back surface of one small cell onto main grid welding points on a front surface of another small cell, and heating so that the two small cells are electrically connected through the conductive adhesive or solder paste (14); and, melting the hot melt adhesive (13) while heating, and solidifying the hot melt adhesive (13) after cooling, so that the two small cells are closely adhered together and the welding points on the two small cells form firm ohmic contact; and
(6) repeating the step (5) for the plurality of small cells so that the plurality of small cells are successively connected to form a solar cell string.

2. The preparation method according to claim 1, wherein there are 3 to 15 main grids (11) each having a width of 100 to 1200 µm.

3. The preparation method according to claim 1 or 2, wherein the cell cutting region (12) has a width of 1 to 2 mm; the hot melt adhesive (13) has a width of 1 to 3 mm, and the welding points are exposed from the hot melt adhesive (13); and, the hot melt adhesive (13) is dried at a temperature of below 150°C after printed.

4. The preparation method according to claim 1 or 2, wherein, in the step (3), the cutting is laser cutting.

5. The preparation method according to claim 1 or 2, wherein, in the step (5), the heating is resistance wire heating or infrared heating.

6. A densely-arranged solar cell string prepared using the method of claim 1, comprising solar cell units, wherein fine grids (10), main grids (11) and main grid welding points are provided on front and back surfaces of the solar cell units, the main grids (11) and fine grids (10) of the solar cell are perpendicular to each other, and the main grid welding points are arranged at ends of the main grids (11), the positions of the main grid welding points on the back surface and the positions of the main grid welding points on the front surface are symmetrical about a center; a hot melt adhesive (13) is coated on the front surfaces of the solar cell units along a direction of the fine grids (10), the hot melt adhesive (13) is disconnected in a region of the main grid welding points, and a conductive adhesive or solder paste (14) is coated at the main grid welding points; the back surface of one solar cell unit is superposed onto the front surface of another solar cell unit along a long-side direction as a direction perpendicular to the main grids (11), and the width of an superposed region of the two solar cell units is the width of the main grid welding points; and, the main welding points on the back surface of one solar cell unit come into ohmic contact with the main grid welding points on the front surface on another solar cell unit through the conductive adhesive or solder paste (14), so that the two solar cell units are bonded together through the hot melt adhesive (13).

7. The solar cell string according to claim 6, wherein electrodes on the back and front surfaces of the solar cell units are H-type electrodes, and the main grids (11) and the fine grids (10) are perpendicular to each other.

8. The solar cell string according to claim 6 or 7, wherein the hot melt adhesive (13) has a width of 1 to 3 mm.

9. A densely-arranged solar cell module, comprising a front layer material, a packaging material, a solar cell string, the packaging material and a back layer material which are successively arranged from the top down, the solar cell string being the solar cell string according to any one of claims 6 to 8.

10. A solar cell system, comprising at least one solar cell module connected in series, wherein the solar cell module is the solar cell module according to claim 9.

## Patentansprüche

1. Verfahren zum Vorbereiten eines dicht-angeordneten Solarzellenstrings, welches die folgenden Schritte umfasst:
(1) Vorbereiten einer Solarzelle, wobei Hauptgitter (11) und Feingitter (10) der Solarzelle senkrecht zueinander sind; wobei die Hauptgitter (11) segmentierte Elektroden sind, und Schweißpunkte für eine elektrische Verbindung zwischen Zellen an Enden der segmentierten Hauptgitter (11) angeordnet sind; wobei die Feingitter (10), die Hauptgitter (11) und die Hauptgitter-Schweißpunkte an vorderen und hinteren Flächen der Solarzelle bereitgestellt sind; wobei die Positionen der Hauptgitter-Schweißpunkte an der hinteren Fläche und die Positionen der Hauptgitter-Schweißpunkte an der vorderen Fläche symmetrisch um ein Zentrum sind; und wobei ein Zellenschneidebereich (12) ferner an der Solarzelle bereitgestellt ist, und der Zellenschneidebereich (12) senkrecht zu den Hauptgittern (11) ist;
(2) Drucken eines streifenförmigen Heißschmelzhaftmittels (13): Drucken des streifenförmigen Heißschmelzhaftmittels (13) an dem Bereich, welcher den Schweißpunkten der segmentierten Hauptgitter (11) entspricht, in einer Richtung senkrecht zu den Hauptgittern (11) und Freilegen der Schweißpunkte;
(3) Schneiden der Zelle: Schneiden, entlang des Zellenschneidebereichs (12), der Solarzelle in eine Mehrzahl von kleinen Zellen;
(4) Beschichten eines leitfähigen Haftmittels oder einer leitfähigen Lötpaste (14): Beschichten des leitfähigen Haftmittels oder der leitfähigen Lötpaste (14) an den Hauptgitter-Schweißpunkten an den vorderen Flächen der kleinen Zellen;
(5) Anhaften der kleinen Zellen: Überlagern von Hauptgitter-Schweißpunkten an einer hinteren Fläche einer kleinen Zelle auf Hauptgitter-Schweißpunkte an einer vorderen Fläche einer anderen kleinen Zelle, und Erwärmen, sodass die zwei kleinen Zellen durch das leitfähige Haftmittel oder die leitfähige Lötpaste (14) elektrisch verbunden werden; und Schmelzen des Heißschmelzhaftmittels (13) während eines Wärmens, und Erhärten des Heißschmelzhaftmittels (13) nach einem Kühlen, sodass die zwei kleinen Zellen nahe aneinander anhaften und die Schmelzpunkte an den zwei kleinen Zellen einen festen ohmschen Kontakt bilden; und
(6) Wiederholen des Schritts (5) für die Mehrzahl kleiner Zellen, sodass die Mehrzahl kleiner Zellen nacheinander verbunden werden, um einen Solarzellenstring zu bilden.

2. Vorbereitungsverfahren nach Anspruch 1, wobei es 3 bis 15 Hauptgitter (11) gibt, welche jeweils eine Breite von 100 bis 1200 µm aufweisen.

3. Vorbereitungsverfahren nach Anspruch 1 oder 2, wobei der Zellenschneidebereich (12) eine Breite von 1 bis 2 mm aufweist; das Heißschmelzhaftmittel (13) eine Breite von 1 bis 3 mm aufweist, und die Schweißpunkte von dem Heißschmelzhaftmittel (13) freigelegt sind; und das Heißschmelzhaftmittel (13) bei einer Temperatur von unter 150°C nach einem Drucken getrocknet wird.

4. Vorbereitungsverfahren nach Anspruch 1 oder 2, wobei, in dem Schritt (3), das Schneiden Laserschneiden ist.

5. Vorbereitungsverfahren nach Anspruch 1 oder 2, wobei, in dem Schritt (5), das Wärmen Widerstandsdrahtwärmen oder Infrarotwärmen ist.

6. Dicht-angeordneter Solarzellenstring, welcher unter Verwendung des Verfahrens nach Anspruch 1 vorbereitet ist, welcher Solarzelleneinheiten umfasst, wobei Feingitter (10), Hauptgitter (11) und Hauptgitter-Schweißpunkte an vorderen und hinteren Flächen der Solarzelleneinheiten bereitgestellt sind, wobei die Hauptgitter (11) und die Feingitter (10) der Solarzelle senkrecht zueinander sind und die Hauptgitter-Schweißpunkte an Enden der Hauptgitter (11) angeordnet sind, wobei die Positionen der Hauptgitter-Schweißpunkte an der hinteren Fläche und die Positionen der Hauptgitter-Schweißpunkte an der vorderen Fläche symmetrisch um ein Zentrum sind; wobei ein Heißschmelzhaftmittel (13) an den vorderen Flächen der Solarzelleneinheiten entlang einer Richtung der Feingitter (10) beschichtet ist, wobei das Heißschmelzhaftmittel (13) in einem Bereich der Hauptgitter-Schweißpunkte unterbrochen ist, und ein leitfähiges Haftmittel oder eine leitfähige Lötpaste (14) an den Hauptgitter-Schweißpunkten beschichtet ist; wobei die hintere Fläche einer Solarzelleneinheit der vorderen Fläche einer anderen Solarzelleneinheit entlang einer Längsseitenrichtung überlagert ist, wie einer Richtung senkrecht zu den Hauptgittern (11), und wobei die Breite eines überlagerten Bereichs der zwei Solarzelleneinheiten die Breite der Hauptgitter-Schweißpunkte ist; und wobei die Haupt-Schweißpunkte an der hinteren Fläche einer Solarzelleneinheit mit den Hauptgitter-Schweißpunkten an der vorderen Fläche einer anderen Solarzelleneinheit durch das leitfähige Haftmittel oder die leitfähige Lötpaste (14) in ohmschen Kontakt kommen, sodass die zwei Solarzelleneinheiten durch das Heißschmelzhaftmittel (13) miteinander verbunden sind.

7. Solarzellenstring nach Anspruch 6, wobei Elektroden an den hinteren und vorderen Flächen der Solarzelleneinheiten H-Typ-Elektroden sind, und die Hauptgitter (11) und die Feingitter (10) senkrecht zueinander sind.

8. Solarzellenstring nach Anspruch 6 oder 7, wobei das Heißschmelzhaftmittel (13) eine Breite von 1 bis 3 mm aufweist.

9. Dicht-angeordnetes Solarzellenmodul, umfassend ein vorderes Schichtmaterial, ein Kapselmaterial, ein Solarzellenstring, das Kapselmaterial und ein hinteres Schichtmaterial, welche nacheinander von oben nach unten angeordnet sind, wobei der Solarzellenstring der Solarzellenstring nach einem der Ansprüche 6 bis 8 ist.

10. Solarzellensystem, welches wenigstens ein Solarzellenmodul umfasst, welches in Reihe geschalten ist, wobei das Solarzellenmodul das Solarzellenmodul nach Anspruch 9 ist.

## Revendications

1. Procédé de préparation d'une chaîne de cellules solaires agencées de manière dense, comprenant les étapes suivantes :
(1) la préparation d'une cellule solaire, dans lequel des grilles principales (11) et des grilles fines (10) de la cellule solaire sont perpendiculaires les unes aux autres ; les grilles principales (11) sont des électrodes segmentées, et des points de soudure pour une connexion électrique entre des cellules sont agencés à des extrémités des grilles principales (11) segmentées ; dans lequel les grilles fines (10), les grilles principales (11) et les points de soudure de grille principale sont fournis sur des surfaces avant et arrière de la cellule solaire ; les positions des points de soudure de grille principale sur la surface arrière et les positions des points de soudure de grille principale sur la surface avant sont symétriques autour d'un centre ; et, une région de découpe de cellule (12) est en outre fournie sur la cellule solaire, et la région de découpe de cellule (12) est perpendiculaire aux grilles principales (11) ;
(2) l'impression d'une colle thermofusible en forme de bande (13) : l'impression de la colle thermofusible en forme de bande (13) au niveau de la région correspondant aux points de soudure des grilles principales (11) segmentées dans une direction perpendiculaire aux grilles principales (11), et l'exposition des points de soudure ;
(3) la découpe de la cellule : la découpe, le long de la région de découpe de cellule (12), de la cellule solaire en une pluralité de petites cellules ;
(4) l'application d'une colle conductrice ou d'une pâte à braser (14) : l'application de la colle conductrice ou de la pâte à braser (14) au niveau des points de soudure de grille principale sur les surfaces avant des petites cellules ;
(5) le collage des petites cellules : la superposition des points de soudure de grille principale sur une surface arrière d'une petite cellule sur des points de soudure de grille principale sur une surface avant d'une autre petite cellule, et le chauffage du tout de sorte que les deux petites cellules soient électriquement connectées par le biais de la colle conductrice ou de la pâte à braser (14) ; et, la fusion de la colle thermofusible (13) pendant le chauffage, et la solidification de la colle thermofusible (13) après un refroidissement, de sorte que les deux petites cellules soient étroitement collées ensemble et que les points de soudure sur les deux petites cellules forment un contact ohmique ferme ; et
(6) la répétition de l'étape (5) pour la pluralité de petites cellules de sorte que la pluralité de petites cellules soient successivement connectées pour former une chaîne de cellules solaires.

2. Procédé de préparation selon la revendication 1, dans lequel il y a 3 à 15 grilles principales (11) ayant chacune une largeur de 100 à 1 200 µm.

3. Procédé de préparation selon la revendication 1 ou 2, dans lequel la région de découpe de cellule (12) a une largeur de 1 à 2 mm ; la colle thermofusible (13) a une largeur de 1 à 3 mm, et les points de soudure sont exposés à partir de la colle thermofusible (13) ; et, la colle thermofusible (13) est séchée à une température inférieure à 150 °C après impression.

4. Procédé de préparation selon la revendication 1 ou 2, dans lequel, dans l'étape (3), la découpe est une découpe au laser.

5. Procédé de préparation selon la revendication 1 ou 2, dans lequel, dans l'étape (5), le chauffage est un chauffage par fil de résistance ou un chauffage infrarouge.

6. Chaîne de cellules solaires agencées de manière dense préparée en utilisant le procédé selon la revendication 1, comprenant des unités de cellules solaires, dans laquelle des grilles fines (10), des grilles principales (11) et des points de soudure de grille principale sont fournis sur des surfaces avant et arrière des unités de cellules solaires, les grilles principales (11) et les grilles fines (10) de la cellule solaire sont perpendiculaires les unes aux autres, et les points de soudure de grille principale sont agencés à des extrémités des grilles principales (11), les positions des points de soudure de grille principale sur la surface arrière et les positions des points de soudure de grille principale sur la surface avant sont symétriques autour d'un centre ; une colle thermofusible (13) est appliquée sur les surfaces avant des unités de cellules solaires le long d'une direction des grilles fines (10), la colle thermofusible (13) est déconnectée dans une région des points de soudure de grille principale, et une colle conductrice ou une pâte à braser (14) est appliquée au niveau des points de soudure de grille principale ; la surface arrière d'une unité de cellules solaires est superposée sur la surface avant d'une autre unité de cellules solaires le long d'une direction du côté long en tant que direction perpendiculaire aux grilles principales (11), et la largeur d'une région superposée des deux unités de cellules solaires est la largeur des points de soudure de grille principale ; et les points de soudure de grille principale sur la surface arrière d'une unité de cellules solaires viennent en contact ohmique avec les points de soudure de grille principale sur la surface avant d'une autre unité de cellules solaires par le biais de la colle conductrice ou de la pâte à braser (14), de sorte que les deux unités de cellules solaires soient liées ensemble par le biais de la colle thermofusible (13).

7. Chaîne de cellules solaires selon la revendication 6, dans laquelle des électrodes sur les surfaces avant et arrière des unités de cellules solaires sont des électrodes de type H, et les grilles principales (11) et les grilles fines (10) sont perpendiculaires les unes aux autres.

8. Chaîne de cellules solaires selon la revendication 6 ou 7, dans laquelle la colle thermofusible (13) a une largeur de 1 à 3 mm.

9. Module de cellules solaires agencées de manière dense, comprenant un matériau de couche avant, un matériau de conditionnement, une chaîne de cellules solaires, le matériau de conditionnement et un matériau de couche arrière qui sont successivement agencés de haut en bas, la chaîne de cellules solaires étant la chaîne de cellules solaires selon l'une quelconque des revendications 6 à 8.

10. Système de cellules solaires, comprenant au moins un module de cellules solaires connecté en série, dans lequel le module de cellules solaires est le module de cellules solaires selon la revendication 9.
